# EUROPEAN PATENT SPECIFICATION

(11) **EP 3 160 072 B1**
(45) Date of publication and mention of the grant of the patent: **02.10.2019**
(21) Application number: 15190476.0
(22) Date of filing: 19.10.2015
(51) Int. Cl.: H04L 1/00

(54) **TRANSCEIVER FOR ASYNCHRONOUS DATA TRANSMISSION OVER A NOISY CHANNEL**
SENDER-EMPFÄNGER FÜR ASYNCHRONE DATENÜBERTRAGUNG ÜBER EINEN RAUSCHENDEN KANAL
ÉMETTEUR-RÉCEPTEUR POUR TRANSMISSION DE DONNÉES ASYNCHRONE SUR UN CANAL BRUITÉ

(43) Date of publication of application: 26.04.2017
(73) Proprietor: Yamar Electronics Ltd., 6249220 Tel-Aviv (IL)
(72) Inventor: MARYANKA, Yair, 6249220 Tel-Aviv (IL)
(74) Representative: Heilein, Ernst - Peter

(56) References cited:
- EP-A2- 0 837 613
- EP-A2- 1 292 060
- EP-A2- 2 045 946
- US-B1- 6 212 230

## Description

### Background of the Invention

The present invention relates to communications over data channels, especially over DC and/or AC power lines, and more specifically to a method and a transceiver for asynchronous data transmission over a noisy channel.

### State of the Art

It is known that electronic devices and system must communicate via data buses to other electronic devices or systems. For instance a Universal Asynchronous Receiver Transmitter (UART) is used in many circumstances to enable device, for instance an integrated circuit or microprocessor, to receive and send data from and to other electronic devices.

To ensure that receiver and transmitter are able to identify payload data a START/STOP-bit synchronization system may be implemented. Said synchronization system inserts a start bit at the head of a data item and a stop bit at the tail of the data item, allowing a receiving device to recognize the head and tail of the transmitted data item without transmitting any sync signal. The data item starting with the start bit and ending with the stop bit may be referred to as a "frame" or "data frame". A state in which no data is transmitted through a communication channel is referred to as an "idle" state (logical value "1"). In response to detection of a start bit, that is usually the logical value "0", the receiving device which is in the idle state detects the start of frame, and start the sampling of the data item. The receiving device continues the sampling for a predetermined data length, and returns to the idle state in response to detection of the stop bit, that is usually logical value "1". Accordingly the receiver or the receiving device may receive subsequent frames in an analogous manner. Further it is conceivable that transmitting device and receiving device may share information such as bit rate, data length, stop bit length, and error detection (parity bit and CRC, channel quality or the like) in advance.

If data frames are to be conveyed over noisy channels, like for instance power lines or the like, it may happen that the receiver will not be able to properly detect the beginning of the data frame, which is the start bit, leading to synchronization problems between the transmitter and the receiver. Furthermore, for improved performance in noise, the data may be protected against errors. The usual methods of protecting a message or data frame are to implement for instance forward error correction codes or the like.

EP 1292060 B1 discloses a signaling method between a plurality of devices interconnected on a noisy channel. To avoid redundant error correction codes the method of EP 1292060 B1 proposes the use of combinations of phase changes or phase shifts to ensure proper transmission of payload data over the power line, hereafter this kind of transmission of data over data channels will be named signaling.

Further EP 0 837 613 A2 discloses an improved messaging protocol for use in a telecommunications network and, more generally, a messaging protocol that efficiently carries control messages between network elements.

Another data transmission method is disclosed in EP 2 045 946 A2 wherein a plurality of different data types may be used. Herein an implementation of a data retransmission scheme to ensure noise protection is described.

Furthermore US 6 212 230 B1 discloses a method and apparatus for data transmission, and more particularly an infrared transmission of data

The known error protection codes are inefficient for protecting short data like for instance only one byte of data especially on noisy channels like power lines, for instance DC and/or AC power lines. Due to the noise on the power line channel, for instance a DC and/or AC power line channel, data degradation may arise leading to an inefficient transmission on this specific data channel.

### Object of the present invention

Therefore, an object of the present invention is to provide a robust transmission method of data independently of its data length, which can be used especially on noisy transmission channels. Furthermore another object of the present invention is to provide a transceiver able to communicate with short messages, and able to overcome the problems of the existing devices.

### Summary of the present invention

According to the present invention a method performed by a transceiver for asynchronously transmitting and/or receiving data over a noisy channel is provided. The method comprises at least following steps: receiving a serial data stream comprising a data frame, said data frame including at least one start bit, payload data and at least one stop bit, said data frame having a predetermined number of bits, forming a signaling preamble having a predetermined length by using at least said start and stop bit periods of said data frame, building a processed data frame by attaching said signaling preamble to said payload data, said processed data frame having the same predetermined number of bits, and modulating said processed data by using a signaling modulation scheme and transmitting said modulated processed data over said noisy channel.

According to the present invention the forming step comprises shifting said stop bit adjacent to the start bit of said data frame. Thus the processed data frame will have the same data length leading to a compatible data format, which may be used in existing transmission systems for instance. Therefore the method according to the present invention is upward and/or downward compatible.

The method according to the present invention receives a serial data stream comprising data frames which may correspond to the UART standard in one embodiment. The data frame is used for asynchronous data transmission wherein no common clocks are needed. The data frame has a predetermined number of bits N which corresponds to the original data length of the original data frame. According to the invention a signaling preamble may be formed, the preamble making use of at least the bit period of the included start and stop bit periods in the original data frame. Thus the entire data length will remain unchanged which in turn means that the present invention will be compatible with already implemented solutions for instance.

According to the invention a processed data frame will be built by attaching a signaling preamble to the payload data by keeping the data length unchanged as in the original data. Thereafter the processed data will be modulated prior transmission on the noisy channel, whereby the signaling preamble will serve as a fingerprint for the receiver to identify that valid data was received or transmitted, accordingly. Thus the signaling preamble serves as an identification signal for valid data, wherein the signaling method of EP 1292060 B1 of the applicant, which is incorporated by reference, may be used according to one embodiment.

The method according to the present invention can be advantageously be implemented for data transmission over DC and/or AC power lines, like for instance in vehicles or cars. Despite of the noise occurred on the data channel the method transmits the data in a robust manner and no need for further error correction codes are needed. It is imaginable that the present invention may be implemented on the basis of AC power lines or even within wireless RF systems, wherein short data lengths especially are to be conveyed.

### Embodiments of the invention

The present invention is defined and limited by the scope of the appended claims. In the following, embodiments not falling within the scope of the appended claims are to be interpreted as examples useful for understanding the present invention. According to one embodiment of the present invention the preamble corresponds to a signaling synchronization sequence of the data frame, wherein the synchronization sequence comprises a predetermined bit length of at least the number of the used start and stop bits. Thereby the bit periods of the start and stop bits can be used to generate the signaling synchronization sequence for the payload leading to a robust data transmission method with no need for error correction codes. Thus in one embodiment the signaling synchronization sequence may be two bits long which are in turn modulated on a carrier to be conveyed over the noisy channel. This signaling fingerprint will in turn be compared with valid fingerprints at the receiver to identify valid data.

According to one embodiment the signaling preamble may be formed on the basis of payload data within the data frame. Hence more than two bit periods to generate the preamble may be used leading to a better robustness while transmitting the data over the noisy channel. On the basis of stored preamble sequences at the receiver it can be determined which value the original data bit of the payload data had. This step is necessary because at least one bit period of the payload data was used for generating the signaling preamble or pattern. Nevertheless due to longer preamble sequences the robustness in terms of data errors on the noisy channel can be significantly increased.

In one embodiment the signaling modulation scheme is a phase shift key (PSK) modulation scheme. Especially the modulation technique as disclosed in EP 1292060 B1 shows satisfying results during transmission of short data lengths over a noisy channel, especially on a DC and/or AC power line.

According to an embodiment of the present invention demodulating of a received signaling data frame is provided, wherein sampling of the received data will be executed and thereafter the sampled data can be entered into a shift register. Thus a quick processing and storing of received data on the receiver site may be performed. The stored data in the register can in turn be easily processed later if needed.

According to one embodiment comparing of the sampled data with reference signaling data patterns stored in a register on the receiver side is provided, and further detecting if a valid signaling preamble was received. By means of this operations proper encoding and reconstructing of valid sent data can be ensured. By using more than one signaling data patterns for the comparison the robustness of the transmission method of the present invention may be increased.

In case of a positive detection of a valid signaling preamble building said original data frame may be performed. Therefore further processing of the received valid data can follow.

The data frame is a universal asynchronous receiver/transmitter interface (UART) data type, RS232, RS485, LIN data type or the like. Therefore the method according to the invention can be implemented in various transmission systems in a flexible manner.

According to another aspect of the present invention a transceiver for asynchronous sending and/or receiving of data over a noisy channel is provided. The transceiver comprises a signal interface or port for receiving a serial data stream comprising a data frame; a register for storing said data frame with a predetermined data length, wherein said data frame including at least one start bit, payload data and at least one stop bit, a processor for processing said data frame by forming a signaling preamble sequence. The processor further comprises a module for generating the signaling preamble sequence on the basis of data bits of the data frame, wherein the processed data frame has the aforementioned predetermined length and wherein said generating of the signaling preamble sequence is provided by using at least said start and stop bit periods of said data frame, wherein said generating comprises shifting said stop bit adjacent to the start bit of said data frame. The transceiver furthermore comprises a modulator for modulating the processed data frame leading to modulated signaling data and a sender to send the modulated signaling data over a noisy channel.

This transceiver architecture is adapted to execute the operational sequence of the method of the present invention. The transceiver architecture may be implemented in a standard integrated circuit like a FPGA, a DSP or the like.

According to one embodiment the transceiver further comprises receiver to receive the modulated signaling data, a demodulator to demodulate the received modulated signaling data; a comparator to compare the preamble sequence with at least one valid preamble signaling sequence stored in a valid sequence register and a module for reconstructing said original data frame. Hence the transceiver can be used in an universal manner as a receiver and/or as a transmitter.

The modulator may be a phase shift key modulator. This technique allows robust transmission and encoding of sent data especially on noisy channels.

In embodiments of the present invention, the modulator unit may furthermore be adapted for encoding the serial bit stream, for instance the processed data frame, using for example AM, FM, QPSK, FSK, MSK, ASK or similar techniques, or a combination of such techniques.

The accompanying figures are included to provide a further understanding of the present invention and are incorporated in and constitute a part of this specification. The drawings illustrate the embodiments of the present invention and together with the description serve to explain the principles of the invention. Other embodiments of the present invention and many of the intended advantages of the present invention will be readily appreciated as they become better understood by reference to the following detailed description. The elements of the drawings are not necessarily to scale relative to each other. Like reference numerals designate corresponding similar parts. The drawings described are only schematic and are nonlimiting. In the drawings, the size of some of the elements may be exaggerated and not drawn on scale for illustrative purposes. The dimensions and the relative dimensions do not correspond to actual reductions to practice of the invention.

### Short description of the figures

The invention is explained in further detail, by way of example and with reference to the accompanying drawings wherein:
- Fig. 1: shows the UART encoding scheme;
- Fig. 2: shows an operational sequence of the method (operational diagram) according to the present invention;
- Fig. 3: depicts the signaling principle according to the present invention on the basis of an UART encoding scheme;
- Fig. 4: schematically shows the transmission path according to the present invention;
- Fig. 5: schematically shows the corresponding receiving path of the present invention; and
- Fig. 6: discloses one embodiment of a transceiver according to the present invention.

### Detailed Description

In the following detailed description, reference is made to the accompanying drawings, which form a part hereof, and in which is shown by way of illustration specific embodiments in which the invention may be practiced. In this regard, directional terminology, such as "top," "bottom," "front," "back," etc., is used with reference to the orientation of the figure(s) being described. Because components of embodiments of the present invention can be positioned in a number of different orientations, the directional terminology is used for purposes of illustration and is in no way limiting. It is to be understood that other embodiments may be utilized and structural or logical changes may be made without departing from the scope of the present invention. The following detailed description, therefore, is not to be taken in a limiting sense, and the scope of the present invention is defined by the appended claims.

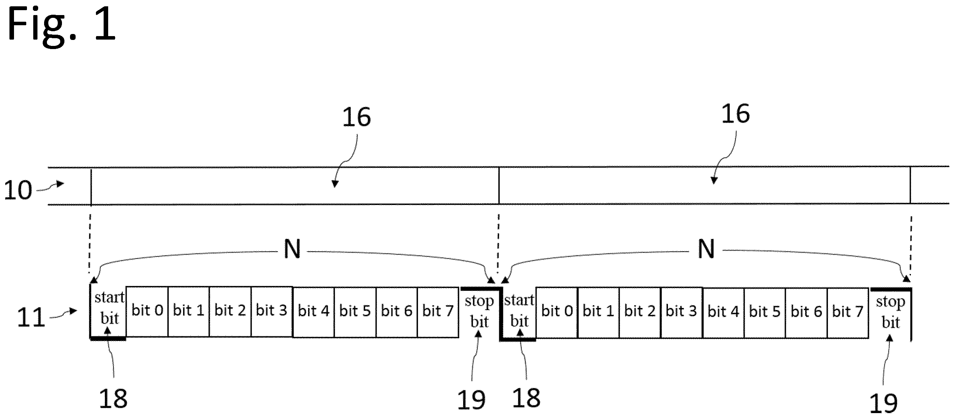

**Fig. 1** shows a usual UART encoding scheme. The UART provides a means of sending and receiving bytes serially over a transmission channel, like for instance a wire or AC and/or DC power line at a specific data rate, namely baud rate. A data stream 10 is shown comprising a number of bytes 11, and the UART encoded data stream 16 is shown below. At the sending end each data byte 16 is enhanced with a start bit 18, stop bit 19 and may also be configured with a parity bit or checksum bit for instance which are not shown below. Each bit is transmitted serially at the pace of the baud rate clock. At the receiving site, the transition between the start bit 18 and stop bit 19 synchronizes the baud rate clock and the received data bits are sampled with the baud rate clock upon reception. The start bit 18, stop bit 19 and any parity bits (not shown) are removed by a processor and the data byte 16 may be placed in a dynamic register or buffer.

This processing of the data bytes is usually embedded in a UART port hardware in a transceiver or the like. The UART interface allows a simple transmission of payload data wherein no coding or decoding is needed. Over noisy channels like for instance AC and/or DC power lines the start bit and stop bit of the data frame may not be detected properly leading to synchronization problems on the receiver for instance. Therefore for detect data errors a message payload checksum mechanism may be provided so that a message check sum is added to each message. This checksum is then validated at the receiving end to check the message integrity. A checksum result different from the expected will cause a message to be rejected. However synchronization problems are not able to be detected by error detection and/or correction codes.

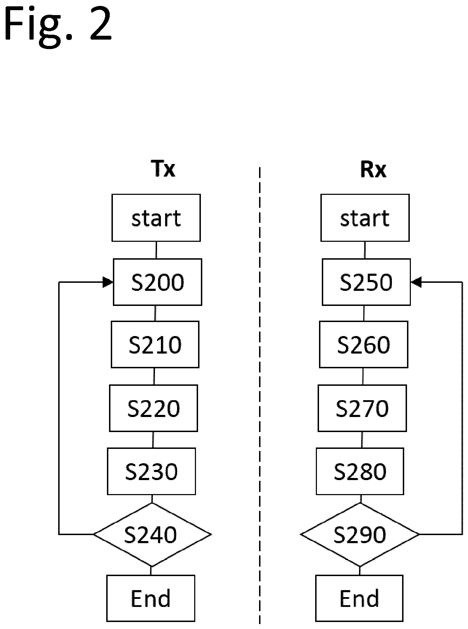

**Fig. 2** shows an operational sequence of the method according to the present invention. In a first step S200 the operational sequence may start by providing a data frame including at least one start bit 18, payload data and at least one stop bit 19, said data frame 16 having a predetermined number of bits N. Such a data frame structure is shown with reference to Fig. 1, wherein one start bit and one stop bit are used. After the data frame 16, which for example may be a UART data frame but also other data format able to be used for an asynchronous data transmission are conceivable to be processed according to the method of the present invention, was provided a signaling preamble may be formed in step S210. The forming step S210 forms the signaling preamble by using the bit periods of the start and stop bit therefore keeping the whole data length N unchanged. After the signaling preamble was formed in step S210, building of a processed data frame S220 will be performed, wherein again the data length of the processed data frame will be identical with the original length of the provided data frame above in step S200. Thus the method can be used in already implemented data transmission systems where the used data lengths were already fixed.

After a processed data frame was provided modulating of said processed data follows according to a modulating step S230. The modulation scheme used may correspond to the technique disclosed in EP 1292060 B1 of the applicant, which is herewith incorporated by reference. The modulated signal is thereafter transmitted S240 over a channel, i.e. a noisy DC and/or AC power line wire for instance in an automobile to a receiver Rx which is in turn connected to the power line system for instance. The method on the transmitter site Tx of the present invention may be restarted if a next original data frame will be provided.

**Fig. 2** shows on the right side the operational sequence on the receiver site according to a possible embodiment of the present invention. During a receiving step S250 a processed data stream, which was generated on the transmitter Tx site according to the present invention, may be further processed. The received data stream belongs to a serial data stream, which has to be encoded on the receiver site. Next demodulating of the received data in step S260 may be performed. Therein the modulated radio frequency signal is demodulated, whereby the base band signal is extracted.

According to the present invention a comparing step S270 is executed wherein the received signaling data frame is compared with reference signaling data patterns stored in a register at the receiver for instance. If a valid signal was detected the CPU in the receiver for instance may rebuild S280 the sent original data and the received data may further be processed. During a decisional step S290 it may be identified if valid data is present and in case of a positive identification the receiving method may stop. If false data was received the receiving method may further be executed in a recursive manner whereby a new modulated data frame may be processed until valid data was encoded.

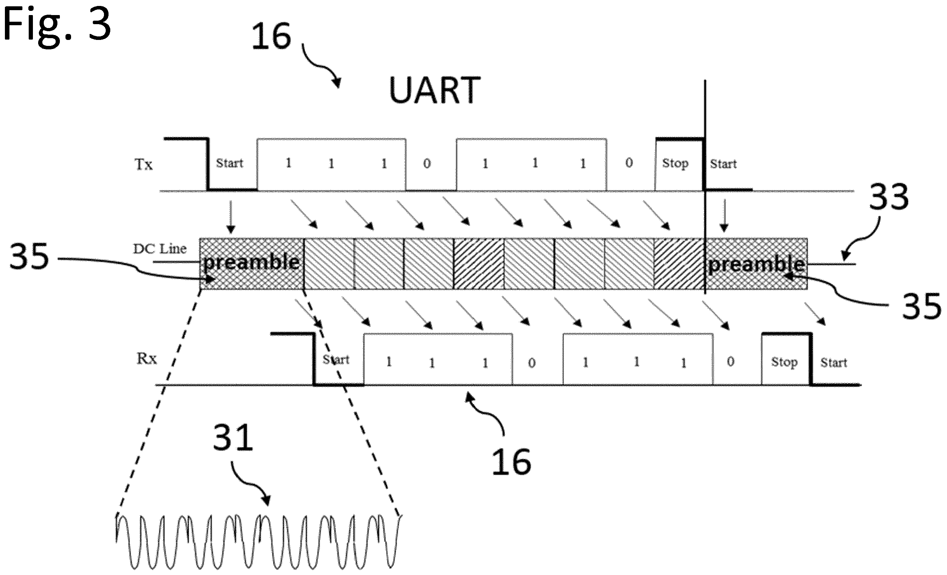

**Fig. 3** schematically shows the principle of the present invention. By the way of example a UART data frame was used comprising one start bit, one stop bit and eight bit of payload data, that is the data lengths is ten bits. According to the present invention a signaling data preamble is generated by keeping the data frame length unchanged, that is according to this embodiment ten bits. It should be understood that different data frame lengths are implementable within the scope of the present invention.

In order to be able to synchronize a single byte of data, a synchronization sequence, herein preamble sequence is required at the beginning of the byte. Said preamble distinguishes between ordinary noise that exist over the power line and the start of the byte. A longer preamble sequence ensures better detection of the unique preamble sequence within the noise occurred in the transmission channel, i.e. DC and/or AC power line. The overall length of the byte cannot be changed because the number of bytes in a message can be infinite. Therefore, the synchronization preamble length determines the byte robustness to noise and interference.

The method according to the present invention suggest to use both the start and stop bits periods of the asynchronous byte as the preamble period, followed by the modulated data bits, keeping the entire byte duration unchanged, which is schematically shown with reference to Fig. 3. On the DC line for instance, the processed data frame 33 is shown comprising a signaling preamble 35 having a length of two bits corresponding to the minimum amount of start and stop bits in the UART frame. With reference 31 the modulated preamble sequence 35 is shown wherein a PSK modulation technique with phase changes was implemented.

For the robust transmission of the data over the noisy channel a PSK modulation scheme may be implemented. At the bottom of Fig. 3 the modulated preamble is schematically shown. It should be noted that the remaining bits of the processed data frame will also be modulated prior the transmission over the noisy channel. For the sake of simplicity only the modulated preamble is shown.

Furthermore, if more than these two bits period may be required for the preamble, it is conceivable to generate two different preamble sequences. The receiver will try to detect both sequences within the noisy channel. If the first sequence is detected, the first data bit will be considered as "1". If the second sequence is detected, the first data bit will be considered as "0". Furthermore, if longer preamble period may be needed, four different preamble sequences can be used for the first two bits of data and so on. Thus the method according to the present invention can be adapted on the basis of the channel transmission quality. That is, the better the channel transmission is the fewer bits for the signaling preamble are needed.

According to a further embodiment the entire byte period of the UART data frame may be divided into two sub periods, where the first sub period is used as preamble and the second sub period is used to transfer the entire data bits. The determination of the necessary length of these sub periods is a balance that depends on the demodulation receiver performance in the expected noisy channel and the required bit rate.

The method is applicable to many existing data types such as RS232, RS485, LIN or the like.

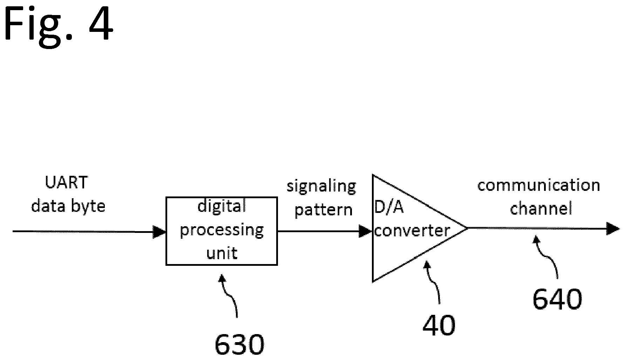

With reference to **Fig. 4** the transmitter according to the present invention is schematically shown. The transmitting side receives the UART data byte. Upon detection of the start bit 18, the digital processing unit or CPU 630 starts to transmit the preamble sequence 35. During this period, the data bits are entered into the digital processing unit 630 and signaling patterns for the payload data are generated according to the entered bits ("0" or "1"). The signaling patterns are converted into an analog signal form by means of a digital to analog converter. The converted data will be in turn transmitted over the DC power line 604 according to one embodiment. It should be noted the communication channel 604 may also be a AC power line connection or the like.

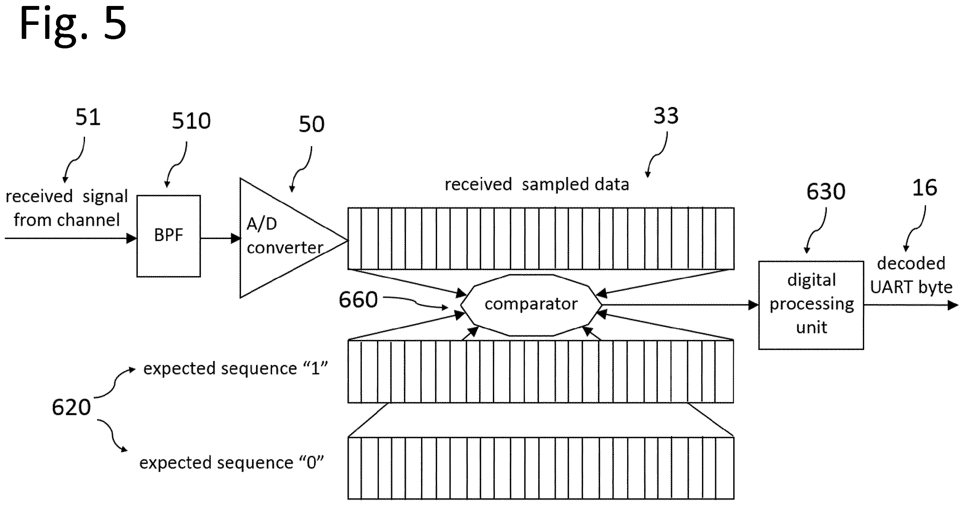

**Fig. 5** shows schematically a receiver according to the present invention that detects sequence of two possible expected sequences ("0" or "1"). Same solution can be used for only one preamble sequence or more sequences. Furthermore, similar circuit can be used to detect also the data pattern bits. The received modulated signal 51, pass through band pass filter 510 and is sampled at high speed by an analog to digital converter 50. The sampled data enter into a shift register 620 where each sampled data is compared with an expected sequence (one or more) that is stored in a memory 62a. If the result of the entire compared shift register values are gathered by the digital processing unit 630. If the calculated values are close enough to the value of the expected sequence, (one or more) the digital processing unit 630 start to detect the rest of the expected data bytes and output the decoded data in the original UART byte format as entered on the transmitting side.

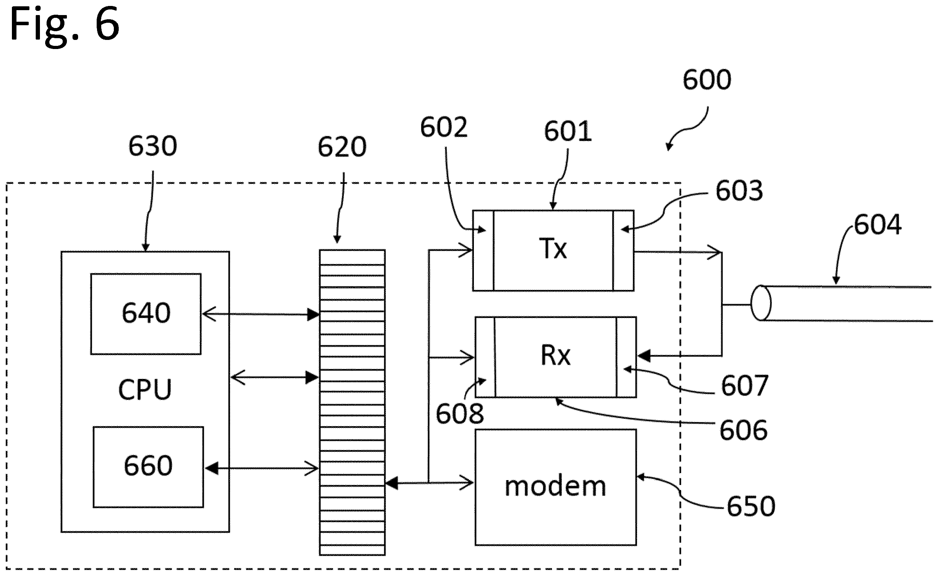

**Fig. 6** shows a possible embodiment of the transceiver 600 according to the present invention. Referring to Fig. 6, a transmitter 601 for transmitting data over a power supply line 604 and a receiver 606 for receiving data transmitted over the power supply line 604 according to embodiments of the present invention are illustrated. According to one exemplary embodiment the transmitter 601 and the receiver 606 are implemented as one device or apparatus as a transceiver 600, but also two functional blocks or separated apparatuses for transmitting and receiving are conceivable.

The transmitter 601 and the receiver 606 are functionally connected, e.g. the transmitter and receiver are apparatuses that complement each other and may work together. For example, the transmitter and receiver may be combined into a modem for data communication.

The transmitter 601 comprises a signal interface or port 602 for receiving a serial bit stream. For example, the serial bit stream may correspond to the processed data frame as explained with reference to Fig. 2, wherein the method according to an embodiment of the present invention is disclosed. The transceiver operating on the basis of the inventive method may provide a robust hardware and software solution for data exchange between different components in vehicles for instance.

The transmitter 601 also comprises a power line interface or port 603 for sending a signal over a power supply line 604, especially a DC power line or wire. The signal interface 602 may be implemented to receive a serial bit stream in form of a processed data frame according to the present invention. The power line connection interface 603 may be adapted for transmitting a signal over a power supply line 604 of the vehicle.

The transmitter 601 further comprises a modulator 605 for generating the modulated signal on the basis of the processed data. The modulator 605 is adapted to encode the processed serial bit stream, e.g. the serial bit stream received via the local signal port 602 and processed according to the method of the present invention described with reference to Fig. 2, into an original signal. The modulation technique may be a phase shift key modulation as disclosed in EP 1292060 B1 of the applicant.

The modulator 605 may implement different modulation techniques such as: amplitude modulation (AM), frequency modulation (FM) or phase modulation (PM) or the like. However, the modulator 605 may also implement digital modulation techniques, such as amplitude shift keying (ASK), frequency shift keying (FSK), minimum shift keying (MSK), or more complex techniques like quadrature phase shift keying (QPSK), or quadrature amplitude modulation (QAM) or the like.

According to an embodiment the modulator 605 is implemented to function according to the modulation technique as disclosed in EP 1292060 B1 of the applicant leading to a robust transmission of short data over noisy channels, especially over the DC power line 604 according to one embodiment.

The receiver 606 within the transceiver 600 may comprise two interfaces 608 and 607 which are interconnected in an analogous manner with reference to the transmitter 601 as shown in Fig. 6.

Further the transceiver 600 comprises a central processing unit 630 or a CPU which is adapted to control the operation of the included modules. The CPU 630 is connected with a register device 620 which may be implemented as a static or dynamic register for instance, but other storage techniques are conceivable. Within the register 620 a valid data register 620a (not shown) may be implemented containing for instance a list of valid signaling preambles which are used for encoding of valid data which was received via the communication channel 604.

The transceiver 600 according to the present invention comprises a module for generating 640 a signaling preamble sequence on the basis of data bits of said data frame, wherein the processed data frame comprises an unchanged number of bits N. The generating module 640 may be implemented as software code running on the CPU 630 but other implementation techniques are conceivable.

For receiving and encoding the data a comparator module or unit 660 may be implemented which compares the received signaling preamble with predetermined valid signaling preambles within a register 620a (not shown) within the transceiver 600. If the comparison step identifies a match valid data was received which can be processed further.

The modem device 650 with reference to Fig. 6 may be implemented to modulate and/or demodulate date which has to be sent and received over the power line 604. The functionality of the modem 650 is not explained in detail herein and should be clear for a person skilled in the art of data communication.

For the sake of simplicity not all connections within the transceiver 600 are depicted, but it should be clear that all units might be interconnected by means of the CPU 630 for instance. According to a further embodiment the transceiver may be implemented on a FPGA for instance wherein suitable firmware code is embodied to operate according to the method of the present invention.

## Claims

1. Method performed by a transceiver (600) for asynchronously transmitting and/or receiving data over a noisy channel, comprising
- Receiving a serial data stream (10) comprising a data frame (S200), said data frame including at least one start bit (18), payload data (16) and at least one stop bit (19), said data frame having a predetermined number of bits N
- Forming a signaling preamble (S210) having a predetermined length by using at least said start and stop bit periods (18, 19) of said data frame, wherein said forming step (S210) comprising shifting said stop bit (19) adjacent to the start bit (18) of said data frame;
- Building a processed data frame (S220) by attaching said signaling preamble (35) to said payload data (16), said processed data frame having the same predetermined number of bits N; and
- Modulating said processed data (S230) by using a signaling modulation scheme and transmitting said modulated processed data (33) over said noisy channel.

2. Method of asynchronous transmission of data according to claim 1, wherein said preamble (35) corresponds to a signaling synchronization sequence of said data frame, said synchronization sequence having a predetermined bit length of at least the number of the used start and stop (18, 19) bits.

3. Method of asynchronous transmission of data according to claim 1 or 2, wherein said signaling preamble is formed on the basis of payload data within said data frame.

4. Method of asynchronous transmission of data according to any of the preceding claims, wherein said signaling modulation scheme is a phase shift key modulation scheme.

5. Method of asynchronous transmission of data according to any of the preceding claims, further comprising receiving (S250) of said processed data frame at a receiver.

6. Method of asynchronous transmission of data, according to any of the preceding claims, further comprising demodulating (S260) said received signaling data frame by sampling said data and entering said sampled data into a shift register.

7. Method of asynchronous transmission of data, according to any of the preceding claims, further comprising comparing (S270) said sampled data with reference signaling data patterns stored in a register on the receiver side, and detecting if a valid signaling preamble was received.

8. Method of asynchronous transmission of data, according to any of the preceding claims, further comprising building (S280) said original data frame in case of a positive detection of said valid signaling preamble.

9. Method of asynchronous transmission of data, according to any of the preceding claims, wherein said data frame is a universal asynchronous receiver/transmitter interface, UART, data type, RS232, RS485, LIN data type or the like.

10. A transceiver (600) for asynchronous sending and/or receiving of data over a noisy channel, comprising:
- A signal interface or port (602) for receiving a serial data stream (10) comprising a data frame; A register (620) for storing said data frame with a predetermined data length N, said data frame including at least one start bit (18), payload data (16) and at least one stop bit (19);
- A processor (630) for processing said data frame by forming a signaling preamble sequence, said processor (630) comprising a module for generating (640) said signaling preamble sequence on the basis of data bits of said data frame, said processed data frame having said predetermined length N wherein said generating of the signaling preamble sequence is provided by using at least said start and stop bit periods (18, 19) of said data frame, wherein said generating comprises shifting said stop bit (19) adjacent to the start bit (18) of said data frame;
- A modulator (650) for modulating said processed data frame leading to modulated signaling data; and
- A sender (601) to send said modulated signaling data over a noisy channel.

11. A transceiver (600) for asynchronous sending and/or receiving of data over a noisy channel according to claim 10, further comprising:
- A receiver (606) to receive said modulated signaling data;
- A demodulator (650) to demodulate said received modulated signaling data;
- A comparator (660) to compare the preamble sequence with at least one valid preamble signaling sequence stored in a valid sequence register (620a); and
- A module (630) for reconstructing said original data frame.

12. A transceiver for asynchronous sending and/or receiving of data over a noisy channel according to claim 10 or 11, wherein said modulator is a phase shift key modulator.

13. A transceiver for asynchronous sending and/or receiving of data over a noisy channel according to any of the preceding claims 10 to 12, wherein said noisy channel is a power line, such as a DC and/or AC power line connection (604).

14. A transceiver for asynchronous sending and/or receiving of data over a noisy channel according to any of the preceding claims 10 to 13 comprising a central processing unit, CPU, adapted to execute the method according to any of the preceding claims 1 to 9.

## Patentansprüche

1. Verfahren, das durch einen Sendeempfänger (600) durchgeführt wird, zum asynchronen Übertragen und/oder Empfangen von Daten über einen rauschbehafteten Kanal, umfassend:
- Empfangen eines seriellen Datenstroms (10), der einen Datenrahmen umfasst (S200), wobei der Datenrahmen mindestens ein Startbit (18), Nutzdaten (16) und mindestens ein Stoppbit (19) enthält,
wobei der Datenrahmen eine vorbestimmte Anzahl von Bits N aufweist;
- Bilden einer Signalisierungspräambel (S210) mit einer vorbestimmten Länge unter Verwendung von zumindest der Start- und Stoppbitperioden (18, 19) des Datenrahmens, wobei der Bildungsschritt (S210) ein Verschieben des Stoppbits (19) angrenzend an das Startbit (18) des Datenrahmens umfasst;
- Erstellen eines verarbeiteten Datenrahmens (S220) durch Anfügen der Signalisierungspräambel (35) an die Nutzdaten (16), wobei der verarbeitete Datenrahmen dieselbe vorbestimmte Anzahl von Bits N aufweist; und
- Modulieren der verarbeiteten Daten (S230) unter Verwendung eines Signalisierungsmodulationsschemas und Übertragen der modulierten verarbeiteten Daten (33) über den rauschbehafteten Kanal.

2. Verfahren zur asynchronen Übertragung von Daten nach Anspruch 1, wobei die Präambel (35) einer Signalisierungssynchronisationssequenz des Datenrahmens entspricht, wobei die Synchronisationssequenz eine vorbestimmte Bitlänge von mindestens der Anzahl der verwendeten Start- und Stoppbits (18, 19) aufweist.

3. Verfahren zur asynchronen Übertragung von Daten nach Anspruch 1 oder 2, wobei die Signalisierungspräambel auf Basis von Nutzdaten im Datenrahmen gebildet wird.

4. Verfahren zur asynchronen Übertragung von Daten nach einem der vorangegangenen Ansprüche, wobei das Signalisierungsmodulationsschema ein Phasenumtastung-Modulationsschema ist.

5. Verfahren zur asynchronen Übertragung von Daten nach einem der vorangegangenen Ansprüche, ferner umfassend Empfangen (S250) des verarbeiteten Datenrahmens an einem Empfänger.

6. Verfahren zur asynchronen Übertragung von Daten nach einem der vorangegangenen Ansprüche, ferner umfassend Demodulieren (S260) des empfangenen Signalisierungsdatenrahmens durch Abtasten der Daten und Eingeben der abgetasteten Daten in ein Schieberegister.

7. Verfahren zur asynchronen Übertragung von Daten nach einem der vorangegangenen Ansprüche, ferner umfassend Vergleichen (S270) der abgetasteten Daten mit Referenzsignalisierungsdatenmustern, die in einem Register an der Empfängerseite gespeichert sind, und Detektieren, ob eine gültige Signalisierungspräambel empfangen wurde.

8. Verfahren zur asynchronen Übertragung von Daten nach einem der vorangegangenen Ansprüche, ferner umfassend Erstellen (S280) des ursprünglichen Datenrahmens im Falle einer positiven Detektion der gültigen Signalisierungspräambel.

9. Verfahren zur asynchronen Übertragung von Daten nach einem der vorangegangenen Ansprüche, wobei der Datenrahmen ein UART-Datentyp (UART: Universal Asynchronous Receiver/Transmitter Interface - universelle asynchrone Empfänger-/Senderschnittstelle), RS232, RS485, ein LIN-Datentyp oder dergleichen ist.

10. Sendeempfänger (600) zum asynchronen Senden und/oder Empfangen von Daten über einen rauschbehafteten Kanal, umfassend:
- eine Signalschnittstelle oder einen Signalport (602) zum Empfangen eines seriellen Datenstroms (10), der einen Datenrahmen umfasst; ein Register (620) zum Speichern des Datenrahmens mit einer vorbestimmten Datenlänge N,
wobei der Datenrahmen mindestens ein Startbit (18), Nutzdaten (16) und mindestens ein Stoppbit (19) enthält;
- einen Prozessor (630) zum Verarbeiten des Datenrahmens durch Bilden einer Signalisierungspräambelsequenz, wobei der Prozessor (630) ein Modul zum Erzeugen (640) der Signalisierungspräambelsequenz auf Basis von Datenbits des Datenrahmens umfasst, wobei der verarbeitete Datenrahmen die vorbestimmte Länge N aufweist, wobei das Erzeugen der Signalisierungspräambelsequenz unter Verwendung von zumindest der Start- und Stoppbitperioden (18, 19) des Datenrahmens bereitgestellt wird, wobei das Erzeugen ein Verschieben des Stoppbits (19) angrenzend an das Startbit (18) des Datenrahmens umfasst;
- einen Modulator (650) zum Modulieren des verarbeiteten Datenrahmens, was zu modulierten Signalisierungsdaten führt; und
- einen Sender (601) zum Senden der modulierten Signalisierungsdaten über einen rauschbehafteten Kanal.

11. Sendeempfänger (600) zum asynchronen Senden und/oder Empfangen von Daten über einen rauschbehafteten Kanal nach Anspruch 10, ferner umfassend:
- einen Empfänger (606) zum Empfangen der modulierten Signalisierungsdaten;
- einen Demodulator (650) zum Demodulieren der empfangenen modulierten Signalisierungsdaten;
- einen Komparator (660) zum Vergleichen der Präambelsequenz mit mindestens einer gültigen Präambelsignalisierungssequenz, die in einem Register (620a) für gültige Sequenzen gespeichert ist; und
- ein Modul (630) zum Rekonstruieren des ursprünglichen Datenrahmens.

12. Sendeempfänger zum asynchronen Senden und/oder Empfangen von Daten über einen rauschbehafteten Kanal nach Anspruch 10 oder 11, wobei der Modulator ein Phasenumtastung-Modulator ist.

13. Sendeempfänger zum asynchronen Senden und/oder Empfangen von Daten über einen rauschbehafteten Kanal nach einem der vorangegangenen Ansprüche 10 bis 12, wobei der rauschbehaftete Kanal eine Stromleitung ist, wie etwa eine DC- und/oder AC-Stromleitungsverbindung (604).

14. Sendeempfänger zum asynchronen Senden und/oder Empfangen von Daten über einen rauschbehafteten Kanal nach einem der vorangegangenen Ansprüche 10 bis 13, umfassend eine Zentralverarbeitungseinheit bzw. CPU (Central Processing Unit), die dazu ausgelegt ist, das Verfahren nach einem der vorangegangenen Ansprüche 1 bis 9 auszuführen.

## Revendications

1. Procédé réalisé par un émetteur-récepteur (600) pour transmettre et/ou recevoir de manière asynchrone des données sur un canal bruyant, consistant :
- à recevoir un flux de données sérielles (10) comprenant une trame de données (S200), ladite trame de données comprenant au moins un bit de début (18), des données de charge utile (16) et au moins un bit de fin (19), ladite trame de données ayant un nombre N prédéterminé de bits ;
- à former un préambule de signalisation (S210) ayant une longueur prédéterminée en utilisant au moins lesdites périodes de bit de début et de fin (18, 19) de ladite trame de données, dans lequel ladite étape de formation (S210) consiste à décaler ledit bit de fin (19) adjacent audit bit de début (18) de ladite trame de données ;
- à construire une trame de données traitées (S220) en joignant ledit préambule de signalisation (35) auxdites données de charge utile (16), ladite trame de données traitées ayant le même nombre N de bits prédéterminé ; et
- à moduler lesdites données traitées (S230) en utilisant un schéma de modulation de signalisation et à transmettre lesdites données traitées modulées (33) sur ledit canal bruyant.

2. Procédé de transmission asynchrone de données selon la revendication 1, dans lequel ledit préambule (35) correspond à une séquence de synchronisation de signalisation de ladite trame de données, ladite séquence de synchronisation ayant une longueur de bit prédéterminée d'au moins le nombre de bits de début et de fin utilisés (18, 19).

3. Procédé de transmission asynchrone de données selon la revendication 1 ou 2, dans lequel ledit préambule de signalisation est formé sur la base de données de charge utile dans ladite trame de données.

4. Procédé de transmission asynchrone de données selon l'une quelconque des revendications précédentes, dans lequel ledit schéma de modulation de signalisation est un schéma de modulation par déplacement de phase.

5. Procédé de transmission asynchrone de données selon l'une quelconque des revendications précédentes, consistant en outre à recevoir (S250) ladite trame de données traitées au niveau d'un récepteur.

6. Procédé de transmission asynchrone de données selon l'une quelconque des revendications précédentes, consistant en outre à démoduler (S260) ladite trame de données de signalisation reçue en échantillonnant lesdites données et à entrer lesdites données échantillonnées dans un registre à décalage.

7. Procédé de transmission asynchrone de données selon l'une quelconque des revendications précédentes, consistant en outre à comparer (S270) lesdites données échantillonnées avec des motifs de données de signalisation de référence stockés dans un registre côté récepteur, et à détecter si un préambule de signalisation valide a été reçu.

8. Procédé de transmission asynchrone de données selon l'une quelconque des revendications précédentes, consistant en outre à construire (S280) ladite trame de données d'origine dans le cas d'une détection positive dudit préambule de signalisation valide.

9. Procédé de transmission asynchrone de données selon l'une quelconque des revendications précédentes, dans lequel ladite trame de données est un type de données d'interface d'émetteur-récepteur universel asynchrone (UART), RS232, RS485, un type de données LIN ou analogue.

10. Émetteur-récepteur (600) pour un envoi et/ou une réception asynchrones de données sur un canal bruyant, comprenant :
- une interface ou un port de signal (602) pour recevoir un flux données sérielles (10) comprenant une trame de données ; un registre (620) pour stocker ladite trame de données ayant une longueur N de données prédéterminée, ladite trame de données comprenant au moins un bit de début (18), des données de charge utile (16) et au moins un bit de fin (19) ;
- un processeur (630) pour traiter ladite trame de données en formant une séquence de préambule de signalisation, ledit processeur (630) comprenant un module pour générer (640) ladite séquence de préambule de signalisation sur la base de bits de données de ladite trame de données, ladite trame de données traitées ayant ladite longueur N prédéterminée, dans lequel ladite génération de la séquence de préambule de signalisation est fournie en utilisant au moins lesdites périodes de bit de début et de fin (18, 19) de ladite trame de données, dans lequel ladite génération consiste à décaler ledit bit de fin (19) adjacent au bit de début (18) de ladite trame de données ;
- un modulateur (650) pour moduler ladite trame de données traitées conduisant à des données de signalisation modulées ; et
- un expéditeur (601) pour envoyer lesdites données de signalisation modulées sur un canal bruyant.

11. Émetteur-récepteur (600) pour un envoi et/ou une réception asynchrones de données sur un canal bruyant selon la revendication 10, comprenant en outre :
- un récepteur (606) pour recevoir lesdites données de signalisation modulées ;
- un démodulateur (650) pour démoduler lesdites données de signalisation modulées reçues ;
- un comparateur (660) pour comparer la séquence de préambule avec au moins une séquence de signalisation de préambule valide stockée dans un registre de séquence valide (620a) ; et
- un module (630) pour reconstruire ladite trame de données d'origine.

12. Émetteur-récepteur pour un envoi et/ou une réception asynchrones de données sur un canal bruyant selon la revendication 10 ou 11, dans lequel ledit modulateur est un modulateur par déplacement de phase.

13. Émetteur-récepteur pour un envoi et/ou une réception asynchrones de données sur un canal bruyant selon l'une quelconque des revendications 10 à 12, dans lequel ledit canal bruyant est une ligne électrique, telle qu'un raccordement de ligne électrique en courant continu (CC) et/ou en courant alternatif (CA).

14. Émetteur-récepteur pour un envoi et/ou une réception asynchrones de données sur un canal bruyant selon l'une quelconque des revendications 10 à 13, comprenant une unité centrale de traitement (CPU) conçue pour exécuter le procédé selon l'une quelconque des précédentes revendications 1 à 9.
